(19) Europäisches Patentamt
European Patent Office
Office européen des brevets

(11) **EP 4 336 684 A1**

(12) **EUROPEAN PATENT APPLICATION**

(43) Date of publication:
**13.03.2024 Bulletin 2024/11**

(21) Application number: **22194904.3**

(22) Date of filing: **09.09.2022**

(51) International Patent Classification (IPC):
$H01S\ 5/065$ (2006.01)  $H01S\ 5/068$ (2006.01)
$H01S\ 5/40$ (2006.01)  $H01S\ 5/00$ (2006.01)
$H01S\ 5/0687$ (2006.01)  $H01S\ 5/12$ (2021.01)

(52) Cooperative Patent Classification (CPC):
H01S 5/0078; **H01S 5/0656; H01S 5/06821;**
**H01S 5/4006;** H01S 5/005; H01S 5/0064;
H01S 5/0071; H01S 5/02325; H01S 5/0687;
H01S 5/12

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Institute of Science and Technology
Austria
3400 Klosterneuburg (AT)**

(72) Inventors:
- **DIORICO, Fritz
  1030 Wien (AT)**
- **HOSTEN, Onur
  1070 Wien (AT)**

(74) Representative: **SONN Patentanwälte GmbH & Co
KG
Riemergasse 14
1010 Wien (AT)**

(54) **A CLOSED LOOP METHOD AND A SYSTEM FOR CONTROLLING AN INJECTION-LOCKED LASER**

(57) The disclosure concerns a closed loop control method and system (16) for controlling an injection-locked laser (11), the method comprising the steps:
- injecting the laser (11) with an optical seed signal (10);
- propagating at least a portion of an optical output signal (15) from the laser (11) as an incident signal (1) onto a detector (2);
- deriving an error signal (9) based on a geometric beam shape of the incident signal (1) on the detector (2);
- controlling at least one operation parameter of the laser (11) responsive to the error signal (9).

Fig. 1

**Description**

The disclosure concerns a closed loop control method for controlling an injection-locked laser and a closed loop control system for controlling an injection-locked laser.

The linewidth of a laser is primarily determined by unwanted effects that do not contribute to the stimulated emission of the laser. The laser can be made to copy the phase correlation of another injected 'seed' laser beam with a much narrower linewidth. This ideally results in a 'slave' laser with the same linewidth as the seed laser. Therefore, injection-locked lasers have a crucial part in modern science and technology, as injection locking enables a narrow linewidth of the laser output. In addition, the injected seed frequency can be altered. The "slave" laser follows the frequency of the injected seed, thus the frequency of the output of the laser can be shifted.

In order to have a stable injection locking and a stable laser output, it is beneficial to control the injection locked laser. For controlling the laser, it is necessary to measure and quantify the output of the laser and to derive an estimator for the deviation of an actual state of the laser relative to a nominal or reference state. A number of methods have been developed over the decades to address the task of finding a suitable measurement and estimator. These include: side-of-fringe intensity methods, polarization based methods, frequency modulation techniques similar to Pound-Drever-Hall (PDH), and lastly, spatial mode interference methods such as tilt locking.

In Diorico, Fritz, Artem Zhutov, and Onur Hosten. "Laser-cavity locking at the 10^(-7) instability scale utilizing beam elipticity." arXiv preprint arXiv:2203.04550 (2022) a method for locking a laser to an optical cavity is presented. A laser beam is directed at an optical cavity. The laser frequency is in resonance (or near resonance) with the cavity. A reflected beam is focused on a quadrupole photodiode with a lens. The method relies on the interference of the fundamental $TEM_{00}$ mode of an optical cavity with second order spatial modes, leading to an elliptic beam on the detector. Based on the ellipticity, an error signal is derived, which is used as a feedback for the laser to achieve stable laser cavity locking. The method is referred to as "squash locking". The publication mentions that a generic squash locking method may be applicable to stabilize laser injection locking. However, the publication does not give a hint how to generalize the disclosed method and does not show how to transpose the disclosed method to injection locking of lasers.

In Ottaway, D. J., et al. "Stabilization of injection-locked lasers using spatial mode interference." IEEE journal of quantum electronics 37.5 (2001): 653-657 a method to stabilize the injection locking of a laser by using tilt locking to generate an error signal is disclosed. The technique relies on the interference of the $TEM_{00}$ mode with a first order spatial mode of the laser output, which is measured by a quadrant photodiode. The quadrant photodiode has the two quarters of the top and bottom halves added together. Therefore, the quadrant photodiode has effectively two active areas each consisting of added sensor regions. At zero frequency difference (in resonance), the two outputs of the photodiode are equal in amplitude but have opposite phases. These two outputs are subtracted, giving a zero resultant output. At nonzero frequency difference, the $TEM_{00}$ field interferes more constructively with one of the $TEM_{01}$ lobes and more destructively with the other. Thus, the signal depends on a shift of the beam or the intensity on the detector as well as on the alignment of the detector relative to the beam. The error signal, however, includes no information on the beam shape. For example, in case the beam shape would change from circular to elliptic, the two outputs would still be equal as long as the ellipse is centred - regardless of the rotation of the elliptical beam on the detector. In addition, the incident laser beam needs to be misaligned with respect to the optical axis of the cavity of the slave laser. In summary, the error signal is sensitive to misalignment of the optical components, in particular the detector. The signal is fed-back to a piezoelectric transducer so as to stabilize the injection-locking by controlling the injection of the master signal.

Further details on the tilt locking technique are disclosed in Shaddock, D. A., M. B. Gray, and D. E. McClelland. "Frequency locking a laser to an optical cavity by use of spatial mode interference." Optics letters 24.21 (1999): 1499-1501.

It is an object of the present invention to provide a method and device for controlling an injection-locked laser in a closed loop, which is robust against alignment drifts and vibrations.

This is achieved by a closed loop control method for controlling an injection-locked laser, the method comprising the steps:

- injecting the laser with an optical seed signal;
- propagating at least a portion of an optical output signal from the laser as an incident signal onto a detector;
- deriving an error signal based on a geometric beam shape of the incident signal on the detector;
- controlling at least one operation parameter of the laser responsive to the error signal.

Further, this is achieved by a closed loop control system for controlling an injection-locked laser comprising:

- a laser, wherein the laser during operation is injected with an optical seed signal,
- a detector,
- optical components for propagating at least a portion of an optical output signal from the laser as an incident signal onto the detector, and

- a controller for deriving an error signal based on a geometric beam shape of the incident signal on the detector, wherein the controller is configured for controlling at least one operation parameter of the laser responsive to the error signal.

To understand how the error signal is generated, the Hermite-Gaussian (HG) spatial modes supported by optical cavities such as a laser cavity should be recalled. These are a set of Transverse Electromagnetic Modes (TEM$_{mn}$), that a cavity, e.g. the cavity of a laser, can support. The subscripts m and n are positive integers for each orthogonal axes in the transverse direction of beam propagation. The sum m + n is called the mode order which can either be odd or even. Starting from a perfectly aligned optical mode coming into an optical laser cavity, odd modes are induced by misaligning the input beam either by tilting or shifting. Even modes on the other hand are induced by focusing/mode mismatch and are independent of tilting or shifting of the beam.

Earlier spatial mode interference implementations such as tilt locking rely on inducing 1$^{st}$ order (TEM$_{01}$ and TEM$_{10}$) modes by tilting/misaligning the input beam. Here, of interest are the fundamental HG modes TEM$_{00}$ labelled '00', and specific second-order HG modes, 2$^{nd}$ order TEM$_{11}$-like modes, that we label '+', which are both even modes. Even modes are induced by mode mismatch and make the presented method insensitive to misalignment drifts that generate 1st order odd modes. For example, a slightly elliptical beam with a horizontal/vertical orientation can mathematically be decomposed into a main '00' component and a small '+' component. For such a laser beam, the phase difference between these two modes encodes the information about ellipticity. Near a '00' resonance, the two modes acquire a differential phase shift, since only one of them resonate given that different order modes are generically non-degenerate. By way of this mechanism, the output signal of the laser can acquire different geometric beam shapes, in particular opposite ellipticities, on opposite sides of the resonance of the optical laser cavity. To harness this effect, the geometric beam shape, in particular the beam shape ellipticity or beam mode shape ellipticity, of the output signal of the laser may be measured. In general, a sensor sensitive to 2$^{nd}$ order spatial modes of the output signal of the laser can be used in the closed control loop for controlling the laser. In principle, this works for any beam polarization and irrespective of the actual beam polarization.

These modes generically possess different resonance frequencies. In terms of the cavity modes, the spatial decomposition of a slightly elliptical beam that is diagonally oriented is given mostly by the TEM$_{00}$ mode with a small contribution of the 'TEM$_{11}$' 2nd order mode. For such a beam, the phase difference between these two modes encodes the information about the departure from circularity. If the optical seed signal is near one of the laser cavities fundamental frequencies, the two modes naturally acquire a differential phase shift since only one of them resonate. This results in a shape change in the output signal. By way of this mechanism, the output signal can be made to acquire opposite ellipticities on opposite sides of the resonance, thus, generating a determinable error signal. To harness this feature, an error signal proportional to the beam shape ellipticity or beam mode shape ellipticity of the output signal may be used.

It is also possible to use the laser's own light emission to enhance itself. This method is commonly called self-injection or self-feedback locking. By taking a small portion of a laser's light and feeding a frequency filtered version of it back into itself, emission of the laser into a narrower frequency band is enhanced further. This results into a narrowing of the laser's linewidth. The closed loop control method for controlling an injection-locked laser and the closed loop control system for controlling an injection-locked laser can be used for both injection locking with a seed signal of an external light source and self-injection locked lasers.

The method and the system are initiated or initially calibrated before the method is used. The setpoint or reference point of the control loop (e.g., comprising a PID controller) is set by starting with a laser and an optical seed signal that are locked. The term "locked" is to be understood in a way that the coupling of the optical seed signal to the laser is as desired. For example, the optical seed signal can be perfectly mode matched to the TEM$_{00}$ laser mode and/or the central frequency of the optical seed signal is in resonance with the laser. In general, at the setpoint a relation of the optical seed signal to the laser is defined. The laser is to be controlled so that the system stabilizes at the setpoint, so that the relation between the laser and the optical seed signal is as constant as possible. This is achieved by deriving an error signal that indicates a deviation from the setpoint. As explained above, the relative change in beam shape with respect to the beam shape at the setpoint can be used to quantify the deviation from the setpoint. In general, the present closed loop control method is not limited to any particular type of control transfer function. Hence, it is not necessary to define a particular setpoint in order to control the at least one operation parameter of the laser. Instead, it may suffice to drive the laser back into an acceptable range of possible operational states, when the error signal indicates that such a range is left and in which direction.

In general, deriving the error signal based on the geometric beam shape of the incident signal means that the error signal is a function, wherein at least one parameter of the function is a parameter characterizing the geometric beam shape of the incident beam. In particular, the error signal can be directly proportional to a geometric beam ellipticity. The beam ellipticity may be defined according to ISO 11145:2018. Alternatively, the eccentricity may be used. The error signal can optionally be zero at the setpoint. The error signal can have a sign and a magnitude, the sign can optionally indicate the direction of the control, i.e. if an operation parameter of the laser should be increased or decreased. The magnitude of the error signal can be an indication of the magnitude of the necessary change of the at least one operation parameter in order to reach the setpoint.

Optionally, a zero-crossing of the error signal lies in an interval between a minimum and a maximum of the error signal, wherein the interval comprises an error signal value corresponding to a determined beam ellipticity of a substantially circular beam, the incident signal acquiring opposite ellipticities on opposite sides of the resonance can be utilized to determine the error signal, which may be used for locking and thus stabilizing the laser beam. The determined error signal can be thought of as an interference between the resonating '00' mode that leaks out of the laser, and the second-order '+' mode that promptly reflects from the laser to form a phase reference. This detection modality is insensitive to alignment drifts and fluctuations, since small misalignments simply generate first-order modes in the mode decomposition. Zero-crossing refers to the error signal having a value of zero.

Optionally, the error signal comprises a minimum, which is optionally a global minimum. Optionally, the error signal comprises a maximum, which optionally is a global maximum. Optionally, there is no further extreme value between the minimum and the maximum. Optionally, the error signal comprises an interval extending from the minimum to the maximum. In the interval is a value corresponding to the laser being locked to the seed signal, which is between the minimum and the maximum. Due to the slope of the error-signal, the error signal is used to control the laser to achieve locking of the laser to the optical seed signal.

The detector may be a photodiode, for example an avalanche photodiode. The detector may be a phase plate or mode converter or comprise a phase plate or mode converter. The detector may translate the incident signal into an electrical signal. However, the detector is not limited to electric signals. For example, the detector may be configured to generate an optical signal based on the incident signal and the controller may be configured to derive the error signal based on the optical signal from the detector. In general, the invention is not limited to any particular form of physical signal that the detector generates based on the incident signal.

For example, at least one operation parameter of the laser is one or more of the following:

- temperature of a laser cavity,
- path length of the laser cavity,
- pumping of the laser cavity,
- phase of the optical seed signal

In general, the path length of the laser cavity is crucial for the mode distribution of the laser. The temperature influences the path length as the path length can increase or decrease depending on the temperature change due to thermal expansion, in particular in case of a semiconductor laser. The pumping can have an influence on the temperature, thus again the path length might be influenced by the pumping. The temperature can optionally be changed by means of a Peltier element or for example by a separate heating element, such as an electrical heating element, and a separate cooling element, such as, for example, a fan.

The pumping of the laser depends on the laser technology and can for example be effected by optical pumping via a further light source, e.g. a further laser. Adjusting the pumping can for example include adjusting the electrical current or changing the intensity and/or frequency of the optical pump light. The phase of the optical seed signal can be for example adjusted by adjusting the light source of the optical seed signal or by adjusting the optical path of the optical seed signal.

In an optional embodiment, the laser is a semiconductor laser and pumping of the laser is effected by an electrical current through the laser cavity. Semiconductor lasers include for example FP (Fabry-Perot) lasers, DFB (Distributed-Feedback) lasers, DBR (Distributed-Bragg reflector) laser or VCSEL (vertical-cavity surface-emitting laser). Other classes of lasers compatible with the presented method include ECDL (external cavity diode lasers) or ECL (external cavity lasers). The pumping of a semiconductor laser can be effected by an electrical current through an active material within the laser cavity. Adjusting the pumping can be effected by adjusting the current.

For example, the detector is a photodiode array comprising at least three photodiodes and wherein deriving the error signal includes determining the geometric beam shape of the incident signal. By using an array of photodiodes, the geometric beam shape of the incident signal can be estimated. In order to estimate the geometric beam shape, at least three photodiodes need to be used in order to differentiate between first order and second (or higher) order spatial modes. In principle, the more photodiodes are used, the better the signal shape can be approximated. In general, determining the geometric beam shape of the incident signal means that a parameter value of at least one parameter characterizing the geometric beam shape is determined. Preferably, the photodiodes are arranged in a rectangular regular grid. It is beneficial to minimize the distance between the single photodiodes so that the measurement is most sensitive towards changes of the beam shape.

The detector may be a quadrant photodiode and deriving the error signal may include determining a diagonal signal of the quadrant photodiode, which diagonal signal is made up of the difference of the sums of signals from diagonal sensor regions of the quadrant photodiode. In this way, the beam shape of the incident signal, in particular the beam ellipticity, can be estimated particularly easily. In particular, the quadrant photodiode is a photodiode with four split sensor regions. The gaps between the sensor regions may be optimized to be as small as possible. In particular, the quadrant photodiode produces electrical currents proportional to the input light from each of four sensor regions. The signal from each of the sensor regions is labelled A, B, C and D, wherein on the quadrant photodiode, the sensor regions are arranged in the order A, D, B, C (e.g. in clockwise direction). This allows the following operation: SUM = A + B + C + D, LR = (A + C) - (B + D), UD = (A + D) - (C + B), and DIAG = (A + B) - (C + D). The beam ellipticity can be measured using the DIAG operation. A zero DIAG signal indicates the lack of beam ellipticity, meaning the laser beam is circular. A non-zero DIAG signal indicates the presence of an elliptic beam on the quadrant photodiode. Opposite signs of the DIAG signal refer to opposite ellipticities. The quadrant photodiode may be an InGaAs-based or a silicon-based detector. The signals may be converted into voltages (e.g. using standard analog electronics with operational amplifiers).

As discussed above, the method and the system are initiated or initially calibrated before the method is used. During the controlling of the injection-locked laser, the initialized or calibrated properties are constant. The error signal can be initially set by means of the following parameters.

For example, propagating the incident signal includes imposing an incident angle of the incident signal onto the detector. The incident angle has an influence on the beam shape of the incident beam on the detector. E.g. a circular beam will appear to have an elliptic beam shape on the detector when the incident angle differs from 90°. An incident beam with an elliptical cross section can appear to have a circular beam shape on the detector with a suitable incident angle. If the detector is a QPD, the DIAG signal can be set to zero by means of the imposed angle. The imposed angle is set once during calibration and remains constant during operation.

In an optional embodiment, propagating the incident signal includes shaping the incident signal, in particular with at least a lens, preferably with at least a shaping lens, in particular at least a cylindrical lens. By shaping the incident signal, an initial error signal when the laser is locked to the optical seed signal can be calibrated. The error signal may be set to zero initially. If the detector is a QPD, the DIAG signal can be set to zero by means of shaping of the incident signal. This can be achieved, for example, if the detector is a QPD and the incident signal is shaped so that the image of the incident signal on the detector is circular. This way, the DIAG signal is zero. The DIAG signal can optionally be used as the error signal without further operations. The position and alignment of beam shaping optics for shaping the incident signal, in particular the at least one lens, preferably the least one shaping lens, in particular the at least one cylindrical lens, is set once during calibration and remains constant during operation.

In another embodiment, propagating the incident signal includes focusing the incident signal onto the detector with a detection lens, preferably with a convex spherical lens.

Optionally, the laser beam is focused and/or diverged in at least a first plane and preferably focused and/or diverged in a second plane (not parallel to the first plane), in particular at a different point along the laser beam's path than the focusing/diverging in the first plane). Focusing the laser beam refers to focusing the laser beam in at least one plane. The position and alignment of detection lens for focusing the incident signal onto the detector, preferably the convex spherical lens, may be set once during calibration and remain constant during operation.

Optionally, propagating the incident signal includes defining an axial distance between the detection lens and the detector such that a transmission peak of the incident signal matches a zero-crossing of the error signal. The transmission peak refers to the resonance of the optical seed signal with the laser. The axial distance between the detection lens and the detector refers to their distance along the path of incident signal. For the method and the device, the positions of the detector and the detection lens are fixed during calibration and remain constant during operation. The relative change of the geometric beam shape of the incident signal is most pronounced at the resonance of the laser with the optical seed signal. Therefore, the method is most sensitive at the transmission peak incident signal, which is also a transmission peak of the optical seed signal. Optionally, the axial distance may be tuned over a tuning interval to determine a curve of the error signal and to set the axial distance.

In another optional embodiment, propagating the incident signal includes defining an axial distance between the laser and the detector such that a transmission peak of the incident signal matches a zero-crossing of the error signal. The positions of the detector and the laser are fixed during calibration and remain constant during operation. The relative change of the geometric beam shape of the incident signal is most pronounced at the resonance of the laser with the optical seed signal. Therefore, the method is most sensitive at the transmission peak of the incident signal, which is also a transmission peak of the optical seed signal. The distance between the laser and the detector influences the Gouy phase between the $TEM_{00}$ mode and the second order spatial modes. The resulting image on the detector can therefore be tuned by adjusting the location of the detector relative to the laser. There are axial distances at which the error signal is purely dispersive and other axial distances at which the error signal is purely absorptive or any signal shape in between absorptive and dispersive. Preferably the error signal is dispersive.

Optionally, deriving the error signal may include applying an offset to the error signal. The error signal is derived the following way: the incident signal on the detector leads to a signal per photodiode of the detector. Depending on the estimator for the shape of the incident signal, these signals are used. For example, if the detector is a QPD, the DIAG operation may be used for estimating the ellipticity of the signal. The error signal may be set to zero initially during calibration. This way, the sign of the error signal indicates the direction of the control, e.g. if an operation parameter of the laser should be increased or decreased. Since for example the DIAG operation might lead to a residual signal even if the incident signal is substantially circular, an additional offset can be applied to set the error signal initially to zero at the setpoint.

In another embodiment an imbalanced detection operation can be utilized. For example, instead of the DIAG operation an imbalanced operated IDIAG can be used: IDIAG = $\varepsilon_1(A + B) - \varepsilon_2(C + D)$, where $\varepsilon_1/\varepsilon_2 \neq 1$ and $\varepsilon_1$ and $\varepsilon_2$ can be set initially so as to set the error signal to zero. This allows the background offset of the diagonal channel to be tuned in order to provide a zero-crossing for the error signal at a desired state (e.g., at the setpoint).

The closed loop control method for controlling an injection-locked laser and the closed loop control system for controlling an injection-locked laser can be utilized for continuously shifting the wavelength of the output signal of an injection-locked laser, with the further step: shifting the wavelength of the optical seed signal, wherein the adjustment of the wavelength of the optical seed signal causes a change of the error signal. Shifting the wavelength of the optical seed signal disturbs the locking of the optical seed signal and the laser, thus the error signal changes. The change of the error signal leads to a feedback to the laser in the controlling step of the method as a response. Thereby, the relation of the laser and the optical seed signal is restored at the shifted wavelength of the optical seed signal. This way, the laser output follows the wavelength of the optical seed signal. The error signal indicates whether the laser is operating at its optimal operation parameters for the laser frequency it is injected with. With this information, an extra layer of feedback can be added to dynamically tune operation parameters of the injected laser. This allows the laser to follow the injection frequency throughout its entire operating range. This optimal range allows continuous tuning of the laser frequency without any interruption. This uninterrupted frequency tuning range is often referred to as 'Mode Hop Free' region. This is a unique property of a semiconductor laser that can range from a few GHz to tens of GHz. This optimal locking range is determined typically by the set operating current and temperature of the bare semiconductor laser. The initial operation parameters are typically set before during initializing or calibrating the system thus, the range is already pre-determined over a central frequency. This central frequency can be dynamically tuned beyond the Mode Hop Free region if information on the laser's optimal locking range exists. Since the native output mode of a semiconductor laser is highly elliptical and the mode being injected is typically circular (or a different level of ellipticity), there will be an error signal that continuously monitors whether the laser parameters are still within the optimal injection range or at the optimal setpoint. With this, the current or the temperature or both can be dynamically tuned to follow the frequency of the injected signal. This allows to create a widely tunable laser frequency over its entire operating range.

Optionally at least the laser, the optical components, and preferably the detector, are integrated on a micro-optics or silicon photonics platform, preferably a silicon chip. This can for example be done by heterogeneous integration of discrete miniaturized elements on a single system-on-a-chip (SoC). For example, state of the art optical packaging technology and high-precision assembly can be utilized to build the system.

In an optional embodiment the system is integrated in a TO-can package or a butterfly mount (BTF) so that the system is easily compatible with common technologies.

Optionally, the method further comprises the step: centering the output signal on the quadrant photodiode by translating the detection lens and/or the quadrant photodiode in the directions perpendicular to the optical axis of the incident signal such that a left-right signal and/or an up-down signal of the quadrant photodiode are minimized, which left-right (LR) signal and up-down (UD) signal are each made up of the difference of the sums of adjacent sensor regions of the quadrant photodiode, wherein the left-right signal and the up-down signal use the sums of different halves of adjacent sensor regions. Optionally, this is performed iteratively and repeatedly. In this way, the incident signal can be aligned perfectly at the quadrant photodiode, such that the best beam fit over the quadrant photodiode active area is achieved and producing the most accurate error signal. Optionally, the translation occurs in two directions, which are perpendicular to one another and to the optical axis of the laser beam.

A limitation to stability is still posed, for example, by residual fluctuations in the incident signal, attributable to the alteration of second-order mode components - affecting the phase reference. To help alleviate this residual limitation, a polarization pre- and post-selection procedure may be utilized, which can be described using the weak-value concept. For this purpose, optionally, the optical seed signal is polarization filtered prior to directing the optical seed signal at the laser and the optical output signal is polarization filtered. Optionally, the laser comprises a birefringent cavity. In this way, technical noise that limits system performance can be coherently suppressed. The device preferably comprises a first polarizing beam splitter (or a first polarizer) for polarization filtering the optical seed signal prior to directing the optical seed signal to the laser. A second polarizing beam splitter (or a second polarizer) is used for polarization filtering the incident signal, in particular before the detector. The polarization filtering may be used in the closed loop control method for controlling an injection-locked laser and in the closed loop control system for controlling an injection-locked laser.

With the polarization degree of freedom included, the cavity reflection coefficient is replaced by a reflection operator $\hat{r}$ acting on the input polarization state $|\psi 1\rangle$. When a post-selection onto state $|\psi 2\rangle$ is made, the resulting effective reflection coefficient $r_w$ is given by the weak-value of the reflection operator

$$r_w = \frac{\langle \psi_2 | \hat{r} | \psi_1 \rangle}{\langle \psi_2 | \psi_1 \rangle} \equiv 1 - \gamma' \frac{1}{1 - i\frac{\delta}{\kappa/2}}$$

(Equation 1)

Here $\delta$ is the optical seed signal to laser frequency detuning, $\kappa$ is the full-width laser linewidth and $\gamma' = A\gamma$, where $\gamma$ is a dimensionless parameter characterizing the roundtrip losses in the laser. The 'amplification' parameter A depends on the specific post-selection, and it is real-valued for linear polarization states $|\psi 1\rangle$ and $|\psi 2\rangle$. While it is a function of polarizer angles, operationally it can be related to the remaining power fraction $|\langle \psi 2|\psi 1\rangle|^2 \approx 1/(2A+1)^2$ after post-selection while the optical seed signal is off-resonant. The right hand side of Equation 1 is of the same form as the reflection from a regular high-finesse cavity, except with a variable loss parameter $\gamma'$ (at fixed $\kappa$). Note that $\gamma<1$, $\gamma=1$, $\gamma>1$ and $\gamma>2$ can be identified respectively with the under-coupled, impedance-matched, over-coupled, and cavity-gain regimes of the laser. The variability of $\gamma'$ can be demonstrated experimentally by observing the post-selection dependence of the reflected power from the laser. The error signal may be given by the imaginary part of the reflection coefficient in Equation 1. Tuning the post-selection to an impedance-matched configuration reduces noise for frequency stabilization purposes. In this configuration, the non-signal-generating beam components incident on the detector are strongly attenuated while signal generating parts are attenuated less, effectively increasing the error signal slope and reducing sensitivity to beam shape or intensity fluctuations.

The optional detection lens may be a convex spherical lens.

The optical seed signal may be shaped prior to being injected into the laser, for example such that the optical seed signal acquires an elliptical geometric beam shape or a circular beam shape.

The method and device can be used with a laser wavelength in a wide range. E.g., the wavelength may be in the ultraviolet range, between 190 nm and 400 nm, the visible range, between 400 nm and 800 nm, in the near-infrared range, between 800 nm and 1800 nm, and/or in the infrared range, between 1800 to at least 3500nm.

Optionally, the error signal is directly proportional to the geometric beam ellipticity of the incident signal.

Optionally, the error signal is substantially zero for a circular incident signal and/or a circular image of the incident signal on the detector.

In general, the invention also concerns a method for monitoring an optical signal extracted from an optical cavity, such as a laser cavity, which is defined in the following. This generalized method is independent of the particular application of the error signal obtained through it. The claims define one specific application of a more general version of this method.

1. A method for monitoring an optical signal extracted from an optical cavity, such as a laser cavity, comprising the steps:

- receiving at least a portion of the optical signal as an incident signal;
- converting the incident signal into an error signal by applying a conversion configuration including:

  - propagating the incident signal onto a detector and
  - deriving the error signal based on a geometric beam shape, in particular based on a beam shape ellipticity, for example as proportional to a beam shape ellipticity, of the propagated incident signal on the detector;

  wherein the error signal has a local minimum and a local maximum,
  wherein the local minimum and the local maximum delimit an interval of error signal values,
  wherein the conversion configuration configures the interval to comprise a zero-crossing of the error signal when the optical cavity is in a target state.

2. The method according to embodiment 1, wherein the conversion configuration configures the interval to comprise an error signal value that corresponds to a substantially circular image of the propagated incident signal on the detector.

3. The method according to embodiment 1 or 2, wherein the detector is a quadrant photodiode and wherein deriving the error signal includes determining a diagonal signal of the quadrant photodiode, which diagonal signal is made up of the difference of the sums of signals from diagonal sensor regions of the quadrant photodiode.

4. The method according to any one of the previous embodiments, wherein propagating the incident signal includes adjusting an incident angle of the incident signal onto the detector.

5. The method according to any one of the previous embodiments, wherein propagating the incident signal includes shaping the incident signal, in particular with a shaping lens, preferably with at least a lens, in particular at least a cylindrical lens.

6. The method according to any one of the previous embodiments, wherein deriving the error signal includes applying an offset to the error signal to set the error signal to zero when the optical cavity is in the target state.

7. The method according to any one of the previous embodiments, wherein propagating the incident signal includes focusing the incident signal onto the detector with a detection lens, preferably with a convex spherical lens.

8. The method according to embodiment 7, wherein propagating the incident beam includes adjusting an axial distance between the detection lens and the detector such that a transmission peak of the incident signal matches a zero-crossing of the error signal.

9. The method according to embodiment 8, wherein adjusting the axial distance of the detection lens and the detector comprises, optionally prior to adjusting the axial distance of the detection lens and the detector along the optical axis of the incident signal such that the transmission peak of the laser beam matches the zero-crossing of the error signal:

- adjusting the axial distance such that an in-plane incident signal waist and an out-of-plane incident signal waist of the incident signal match with a beam waist of a resonance cavity mode of the optical cavity.

10. The method according to embodiment 3 and any one of embodiments 7 to 9, further comprising the step:

- centering the incident signal on the quadrant photodiode by translating the detection lens and/or the quadrant photodiode in the directions perpendicular to the optical axis of the incident signal such that a left-right signal and/or an up-down signal of the quadrant photodiode are minimized, which left-right signal and up-down signal are each made up of the difference of the sums of adjacent sensor regions of the quadrant photodiode, wherein the left-right signal and the up-down signal use the sums of different halves of adjacent sensor regions.

11. The method according to embodiment 10, wherein the step of adjusting an axial distance of the detection lens and the quadrant photodiode along the optical axis of the incident signal such that the transmission peak of the incident signal matches the zero-crossing of the error signal and the step of centering the incident signal on the quadrant photodiode are conducted iteratively.

12. A method for frequency locking a laser to an optical cavity with the method according to any one of embodiments 7 to 11, further comprising the steps:

- providing a laser beam from the laser;
- shaping the laser beam such that the laser beam acquires ellipticity;
- directing the laser beam at the optical cavity wherein the laser beam reflected from the optical cavity is the incident signal propagated onto the detector;
- locking the laser to the optical cavity based on the error signal.

13. The method according to embodiment 12, wherein shaping the laser beam such that the laser beam acquires ellipticity is effected by a pair of cylindrical lenses, which have focusing axes oriented non-parallelly, in particular perpendicularly, to each other and/or shaping the laser beam such that the laser beam acquires ellipticity is effected by a combination of lenses, wedged prisms, and/or anamorphic prism pairs, wherein an elliptical or astigmatic beam is created.

14. The method according to embodiment 12 or 13, wherein the laser beam is polarization filtered prior to directing the laser beam at the optical cavity and the incident signal is polarization filtered, wherein optionally the optical cavity is birefringent.

15. The method according to any one of embodiments 1 to 11, further comprising the steps:

- adjusting the optical cavity to reach the target state by minimizing the error signal.

16. The method according to embodiment 15, wherein adjusting the optical cavity includes one or more of the following steps:

- adjusting the temperature of the optical cavity,
- adjusting the path length of the optical cavity.

17. The method according to any one of the previous embodiments, wherein the optical cavity is the optical cavity of a laser, in particular the optical cavity of a semiconductor laser.

18. The method according to embodiments 16 and 17, wherein adjusting the optical cavity includes the following step:

- adjusting the current of the semiconductor laser.

By way of example, the disclosure is further explained with respect to some selected embodiments shown in the drawings for purposes of illustration. However, these embodiments shall not be considered limiting for the disclosure.

Fig. 1 schematically illustrates a beam ellipticity detection using a quadrant photodiode.

Fig. 2 illustrates an error signal as a function of the detuning of the laser relative to an optical seed signal.

Fig. 3 schematically shows an example of a closed loop control system for controlling an injection-locked laser with an external optical seed signal.

Fig. 4 schematically shows an example of a closed loop control system for controlling a self-injection-locked laser, using a portion of the output signal of the laser as the optical seed signal.

Fig. 5 shows an example of a closed loop control system for controlling a self-injection-locked laser with an external cavity providing the reflected signal for self-injection.

Fig. 6 shows an example of a closed loop control system for controlling a self-injection-locked with an external cavity providing the reflected signal for self-injection, with a second detector between the laser and the external cavity.

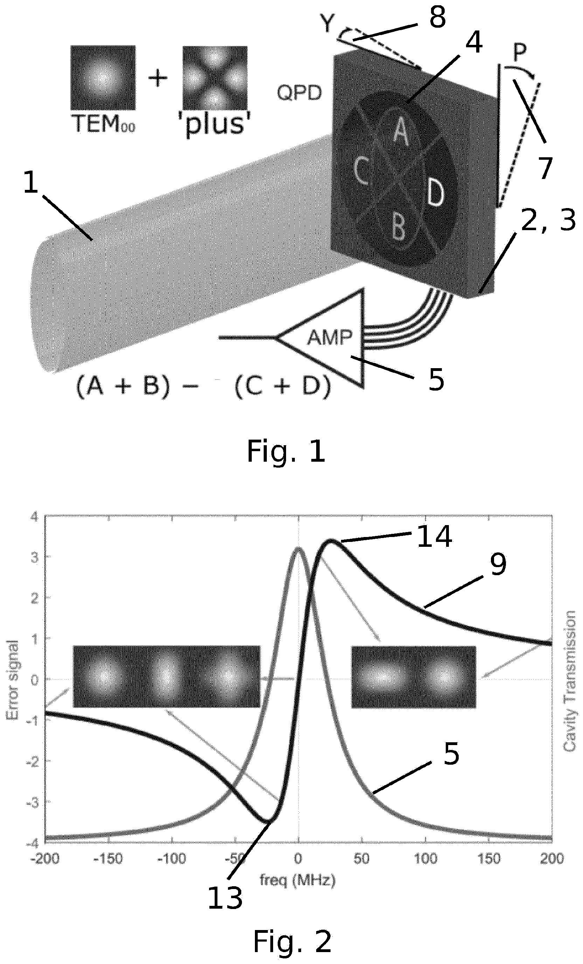

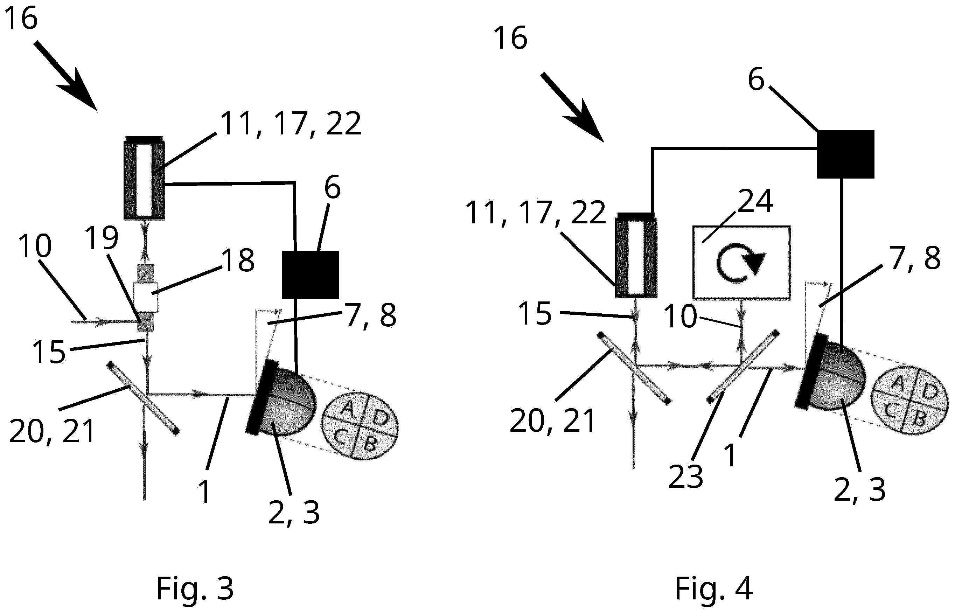

Fig. 1 shows a beam ellipticity detection of an incident signal 1 using a detector 2 and the mode decomposition of a slightly elliptical beam. The detector 2 is a quadrant photodiode (QPD) 3 with four sensor regions 4. The quadrant photodiode 3 produces electrical currents proportional to the input light from each of four sensor regions 4. Deriving the error signal 9 (not shown in fig. 1, see fig. 2) includes determining a diagonal signal of the quadrant photodiode 3, which diagonal signal is made up of the difference of the sums of signals from diagonal sensor regions 4 of the quadrant photodiode 3. The signal from each of the sensor regions 4 is labelled A, B, C and D, wherein on the quadrant photodiode 3, the sensor regions 4 are arranged in the order A, D, B, C (e.g. in clockwise direction). This allows the following operation: SUM = A + B + C + D, LR = (A + C) - (B + D), UD = (A + D) - (C + B), and DIAG = (A + B) - (C + D). The beam ellipticity (or a parameter directly proportional to the beam ellipticity; depending on the rotational alignment of the detector and the cavities determining the relevant modes) can be measured using the DIAG operation, as can be seen in fig. 2. A zero DIAG signal indicates the lack of beam ellipticity, meaning the geometric beam shape of the incident signal 1 is circular. A non-zero DIAG signal indicates the presence of an elliptic incident signal 1 on the quadrant photodiode 3. Opposite signs of the DIAG signal indicate opposite ellipticities. The quadrant photodiode 3 can be an InGaAs-based or a silicon-based detector. The signals are further converted into voltages. Further, the error signal 9 is generated with a transimpedance filter (AMP) 5, e.g. using standard analog electronics with operational amplifiers, and a controller 6 (not shown in fig. 1). The incident angle or incident angles P 7 and Y 8 of the incident optical signal 1 onto the detector 2 can be varied by tilting either the detector 2 with respect to the optical axis of the incident signal 1, or by tilting the optical axis of the incident signal 1 with respect to the main extension plane of the detector 2 (e.g., by tilting a mirror upstream of the quadrant photodiode 3). The relative change of the geometric beam shape of the incident signal 1 is most pronounced at the resonance of the laser with the optical seed signal 10 (not shown in fig. 1, see fig. 3). Therefore, the method is most sensitive at the transmission peak of the incident signal 1, which is also a transmission peak of the optical seed signal 10. The distance between the laser 11 and the detector 2 influences the Gouy phase between the $TEM_{00}$ mode and the second order spatial modes. The resulting image on the detector 2 can therefore be tuned by adjusting the location of the detector 2 relative to the laser 11. The positions of the detector 2 and the laser 11 are fixed during calibration and remain constant during operation. There are axial distances at which the error signal 9 is purely dispersive and other axial distances at which the error signal 9 is purely absorptive or any signal shape in between absorptive and dispersive.

Fig. 2 illustrates a frequency dependence of an error signal 9 for an optical seed signal 10 (not shown in fig. 2) near the '00' mode resonance of the laser 11 (not shown in fig. 2), whereas the DIAG signal is used as the error signal 9. This error signal 9 is dispersive. Note that in this case the native output of the laser 11 has a circular geometric beam shape and the optical seed signal 10 also has a circular beam shape. The error signal 9 comprises a zero-crossing at zero detuning of the laser 11 relative to the optical seed signal 10. This also corresponds to a substantially circular incident signal 1 on the detector 2. Depending on the detuning, the geometric shape of the incident signal 1 changes from circular to elliptic, leading to a non-zero error signal 9. The sign of the error signal 9 shows the orientation of an elliptic incident signal 1. At zero detuning, the transmission 12 of the incident signal 1 through the cavity of the laser 11 has a peak. The zero-crossing of the error signal 9 lies in an interval between a global minimum 13 and a global maximum 14 of the error signal 9. The interval comprises an error signal 9 value corresponding to a determined ellipticity of the incident signal 1. The incident signal 1 acquires opposite ellipticities on opposite sides of the peak of the transmission 12. This is utilized to determine the error signal 9, which is further used for controlling the laser 11 and thus stabilizing the laser output signal 15. The incident signal 1 can be thought of as an interference between the resonating '00' mode that leaks out of the laser 11, and the second-order '+' mode that promptly reflects from the laser 11 to form a phase reference. Due to this detection modality, the error signal 9 is insensitive to alignment drifts and fluctuations, since small misalignments generate (essentially only) first-order modes in the mode decomposition of the incident signal 1. Due to the slope of the error-signal 9, the error signal 9 is used to control the laser 11 to achieve locking of the laser to the optical seed signal 10.

Fig. 3 shows a closed loop control system 16 for controlling an injection-locked laser 11 with an external optical seed signal 10. The laser 11 is a semiconductor laser 17 and produces an optical output signal 15. An optical isolator 18 with a seed injection port 19 is used, through which the external optical seed signal 10 is injected in the laser 11. The frequency of the injected optical seed signal 10 is at or near resonance of the laser 11. The optical isolator 18 prevents the optical output signal 15 from the laser 11 from being re-injected into the laser 11. The system includes an optical component 20 for propagating at least a portion of the output signal 15 from the laser 11 as an incident signal 1 onto the detector 2. The optical component 20 is a beam splitter 21, which is used to split the output signal 15. The reflected portion at the beam splitter 21 is further directed towards the detector 2 and is used as the incident signal 1, which is propagated onto the detector 2. The axial distance between the laser 11 and the detector 2 is such that a transmission 12 peak of the incident signal 1 matches a zero-crossing of the error signal 9.

The beam splitter 21 can for example reflect less than 1% of the incoming intensity. The detector 2 is inclined with respect to the optical axis of the incident signal 1. The detector 2 is a QPD 3, as explained in connection with fig. 1. A controller 6 is configured to receive signals from the sensor regions 4 of the QPD 3 to derive an error signal 9 based on a geometric beam shape, in this case based on the ellipticity. Deriving the error signal 9 includes applying an offset to the error signal 9 in a way that the error signal 9 at the setpoint is zero. The setpoint is determined by the target state of the laser cavity 22 of the laser 11. For example, the target state is achieved when the optical seed signal 10 is perfectly mode matched to the $TEM_{00}$ laser mode and/or the central frequency of the optical seed signal 10 is in resonance with the laser. The controller 6 is configured to control one or more operation parameters of the laser 11 based on the error signal 9 to stabilize the laser 11 to the setpoint. Operation parameters of the laser 11 with a laser cavity 22 include:

-   temperature of a laser cavity 22,
-   path length of the laser cavity 22,
-   pumping of the laser cavity 22,
-   phase of the optical seed signal 10.

The system 16 can also be used for continuously shifting the wavelength of the output signal 15 of the injection-locked laser 11 by shifting the wavelength of the optical seed signal 10. The adjustment of the wavelength of the optical seed signal 10 causes a change of the error signal 9. The change in the error signal 9 causes the controller 6 to control at least one operation parameter of the laser 11 to restore the relation between the laser 11 and the optical seed signal 10, in other words to reach the setpoint. Thus, by shifting the wavelength of the optical seed signal 10, the wavelength of the optical output of the laser 11 can be shifted due to the tracing effected by the closed control loop.

The laser 11, the beam splitter 21 and the detector 2 can be integrated on a common micro-optics or silicon photonics platform (not shown in the figures).

Fig. 4 shows another closed loop control system 16 for controlling a self-injection-locked laser 11, using a portion of the output signal 15 of the laser 11 to inject it back into the laser 11. Compared to the setup of fig. 3, a second beam splitter 23 is used to propagate a portion of the output signal 15 of the laser 11 to a frequency selective back-reflector 24. The optical isolator 18 is omitted. The second beam splitter 23 can have any splitting ration, in particular a splitting ratio of 50/50 is beneficial in the shown setup. The frequency selective back-reflector 24 can be any optical element that reflects back at least a fraction the laser power into the laser 11, thus effecting self-injection. It can for example be a mirror (in which case it may not be frequency selective), an optical grating, a resonant optical cavity or any optical element that reflects back at least a portion of incoming optical power. Preferably the back-reflector 24 reflects back a certain wavelength of light, to achieve a narrow linewidth of the optical seed signal 10 and consequently a narrowing of the output signal 15 of the laser 11. In this embodiment, it is beneficial to have an imposed angle 7,8 of the detector different to 0° of the optical axis of the incident signal 1 relative to a normal vector of the main extension plane of the active area of the detector 2. This minimizes reflection from the detector surface from circulating back into the laser 11. In addition, the imposed angle 7,8 can be used to tune the error signal 9 during calibrating the system 16. Alternatively, the detector surface may be used as back-reflector 24 for self-injection and a different parameter than the imposed angle may be used for calibrating the error signal 9.

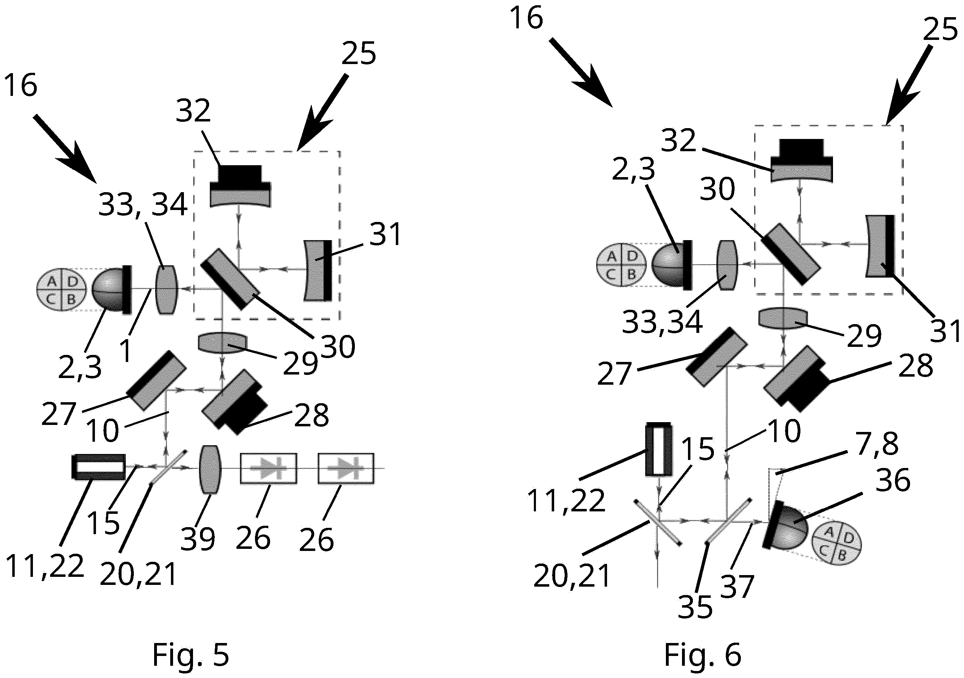

Fig. 5 shows another embodiment of the closed loop control system 16 for controlling a self-injection-locked laser 11. The optical seed signal 10 is generated by propagating a portion of the output signal 15 of the laser 11 through an optical cavity 25, which serves as a back-reflector 24. The spectral transmission of the optical cavity 25 depends on the optical path length of the optical cavity 25. Thus, by controlling the optical path length of the optical cavity 25, the optical seed signal 10 can be controlled and thus the output signal 15 of the laser 11 can be shifted.

The laser 11 has an output signal 15, which is split by a beam splitter 21. The transmitted portion is in this embodiment further shaped by a lens 39 and propagated through optical isolators 26. The beam splitter 21 reflects a portion of the output signal 15. By means of a mirror 27 and piezo-mounted mirror 28, the fraction of the output signal 15 is propagated to the optical cavity 25. Before the optical cavity 25, a lens 29 is used to mode match the optical output signal 15 to the optical cavity 25, which optical cavity 25 is formed by a second beam splitter 30, a second mirror 31 and second piezo-mounted mirror 32. The second piezo mounted mirror 32 is used to determine the spectral transmission through the optical cavity 25. The optical cavity 25 is configured in a way that the reflected intensity at the second beam splitter 30 is propagated to a detection lens 33 and onto the detector 2, which is a QPD 3. The detection lens 33 is a convex spherical lens 34.

The transmitted intensity through the second beam splitter 30 and through the optical cavity 25 is reflected back towards the laser 11 and therefore provides the optical seed signal 10 for self-injecting the laser 11.

The controller 6 (not shown in fig. 5; see fig. 3) derives the error signal 9 and controls one or more of the operation parameters of the laser 11 responsive to the error signal 9. These parameters include:

- temperature of the laser cavity 22,
- path length of the laser cavity 22,
- pumping of the laser cavity 22,
- phase of the optical seed signal 10.

The phase and the injection of the optical seed signal 10 can be manipulated by the piezo controlled mirror 28.

In this example, the laser 11 is a standard Eagleyard DFB 780nm 100mW laser. The external optical cavity 25 assembly is formed by three mirrors: concave [r=10cm], plane, concave. The cavity has a linewidth of 10 MHz. The L-shape of the optical cavity 25 allows easy mode-matching and access to the reflected beam as an incident signal 1 on the detector 2. However, many different cavity geometries can be used including a confocal 2-mirror cavity, as long as the promptly reflected beam is not reflected directly back into the laser - only the intra-cavity circulating light is to be self-injected into the laser.

Fig. 6 shows another embodiment of the closed loop control system 16 for controlling a self-injection-locked laser 11. Compared to the embodiment of fig. 5, a third beam splitter 35 is used and a second detector 36 is configured to receive a second incident signal 37 transmitted through the third beam splitter 35. The second detector 36 is a QPD. The embodiment of fig. 6 is a combination of the embodiments of figures 4 and 5. The addition of the second detector 36 leads to a second error signal 38 (not shown but similar to error signal 9, details see figs 1 and 2) that is used to monitor the injection status of the laser 11 (as in the embodiment of fig. 4), the resulting error signal 38 is specifically used by the controller 6 (not shown in fig. 6; see fig. 3) to control one or more of the following operation parameters of the laser 11:

- temperature of the laser cavity 22,
- path length of the laser cavity 22,
- pumping of the laser cavity 22.

In this embodiment, the error signal 9 of the detector 2 is used by the controller 6 to stabilize the phase of the optical seed signal 10. The incident signals on the detectors 2 and 36 can be understood as an interference between the resonating $TEM_{00}$ mode of an optical cavity, such as the laser cavity, and the second-order '+' mode that promptly reflects from the optical cavity to form a phase reference. In the case of the detector 2, the signal is based on an interference of the $TEM_{00}$ mode of the optical cavity 25 with the output signal 15 of the laser 11.

The signal at the second detector 36 however, is based on an interference of the $TEM_{00}$ mode of the laser cavity 22 with the transmitted signal through the optical cavity 25, which is back-reflected to the laser 11 to serve as the optical seed signal 10 and reflected from the laser cavity 22 to form a phase reference. It is therefore beneficial to use the error signal 9 based on the signal on the (first) detector 2 to adjust the phase between the laser cavity 22 and the optical cavity 25 (which is also the phase of the optical seed signal) by means of the piezo-mounted mirror 28 and to use the second error signal 38 based on the signal at the second detector 36 to control one or more of the remaining operation parameters of the laser 11. The use of two detectors 2 and 36 in this embodiment yields a more stable setup as more information on the injection locking is available and used for controlling the operation parameters.

Further embodiments are disclosed in a prior European patent application under application number 21216871.0 and are included in this application herewith by reference.

**Claims**

1. A closed loop control method for controlling an injection-locked laser (11), the method comprising the steps:

   - injecting the laser (11) with an optical seed signal (10);
   - propagating at least a portion of an optical output signal (15) from the laser (11) as an incident signal (1) onto a detector (1);
   - deriving an error signal (9) based on a geometric beam shape of the incident signal (1) on the detector (2);
   - controlling at least one operation parameter of the laser (11) responsive to the error signal (9).

2. The method according to claim 1, wherein the at least one operation parameter of the laser (11) is one or more of the following:

   - temperature of a laser cavity (22),
   - path length of the laser cavity (22),
   - pumping of the laser cavity (22),
   - phase of the optical seed signal (10).

3. The method according to claim 1 or 2, wherein the laser (11) is a semiconductor laser (17) and pumping of the laser (11) is effected by an electrical current through the laser cavity (22).

4. The method according to any one of the previous claims, wherein the detector (2) is a photodiode array comprising at least three photodiodes and wherein deriving the error signal (9) includes determining the geometric beam shape of the incident signal (1).

5. The method according to any one claims 1 to 3, wherein the detector (2) is a quadrant photodiode (3) and wherein deriving the error signal (9) includes determining a diagonal signal of the quadrant photodiode (3), which diagonal signal is made up of the difference of the sums of signals from diagonal sensor regions (4) of the quadrant photodiode (3).

6. The method according to any one of the previous claims, wherein propagating the incident signal (1) includes imposing an incident angle (7,8) of the incident signal (1) onto the detector (2).

7. The method according to any one of the previous claims, wherein propagating the incident signal (1) includes shaping the incident signal (1), in particular with at least a lens, preferably with at least a shaping lens, in particular at least a cylindrical lens.

8. The method according to any one of the previous claims, wherein propagating the incident signal (1) includes focusing the incident signal (1) onto the detector (2) with a detection lens (33), preferably with a convex spherical lens (34).

9. The method according to claim 8, wherein propagating the incident signal (1) includes defining an axial distance between the detection lens (33) and the detector (2) such that a transmission peak of the incident signal (1) matches a zero-crossing of the error signal (9).

10. The method according to any one of the previous claims, wherein propagating the incident signal (1) includes defining an axial distance between the laser (11) and the detector (2) such that a transmission peak of the incident signal (1) matches a zero-crossing of the error signal (9).

11. The method according to any one of the previous claims, wherein deriving the error signal (9) includes applying an offset to the error signal (9).

12. A method for continuously shifting the wavelength of the output signal (15) of an injection-locked laser (11) with the method according to any of claims 1 to 12 further comprising the step:

    - shifting the wavelength of the optical seed signal (10), wherein the adjustment of the wavelength of the optical seed signal (10) causes a change of the error signal (9).

13. A closed loop control system (16) for controlling an injection-locked laser (11) comprising:

    - a laser (11), wherein the laser (11) during operation is injected with an optical seed signal (10),
    - a detector (2),
    - optical components (20) for propagating at least a portion of an optical output signal from the laser as an incident signal onto the detector (2), and
    - a controller (6) for deriving an error signal (9) based on a geometric beam shape of the incident signal (1) on the detector (2), wherein the controller (6) is configured for controlling at least one operation parameter of the laser (11) responsive to the error signal (9).

14. The control system according to claim 13, wherein at least the laser (11), the optical components (20), and preferably the detector (2), are integrated on a micro-optics or silicon photonics platform, preferably a silicon chip.

Fig. 1

Fig. 2

Fig. 4

Fig. 3

Fig. 5

Fig. 6

EP 4 336 684 A1

Europäisches
Patentamt

European
Patent Office

Office européen
des brevets

## EUROPEAN SEARCH REPORT

Application Number

EP 22 19 4904

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | OTTAWAY D J ET AL: "Stabilization of Injection-Locked Lasers Using Spatial Mode Interference", IEEE JOURNAL OF QUANTUM ELECTRONICS, IEEE, USA, vol. 37, no. 5, 1 May 2001 (2001-05-01), XP011052626, ISSN: 0018-9197 * page 653, right-hand column, paragraph 2 – page 657, left-hand column, paragraph 1; figure 2 * ----- | 1-11,13, 14 | INV. H01S5/065 H01S5/068 H01S5/40 ADD. H01S5/00 H01S5/0687 H01S5/12 |
| X | US 2007/115782 A1 (ANDERSEN OLE K [NL] ET AL) 24 May 2007 (2007-05-24) | 1-13 | |
| Y | * paragraphs [0021] – [0041]; figures 1-5 * ----- | 1-14 | |
| Y | LIU YUN ET AL: "Injection locking of broad-area semiconductor lasers for free-space laser communication", SPIE SMART STRUCTURES AND MATERIALS + NONDESTRUCTIVE EVALUATION AND HEALTH MONITORING, 2005, SAN DIEGO, CALIFORNIA, UNITED STATES, vol. 4821, 1 December 2002 (2002-12-01), page 259, XP93019228, US ISSN: 0277-786X, DOI: 10.1117/12.450938 ISBN: 978-1-5106-4548-6 * page 259, paragraph 4 – page 262, paragraph 2; figures 1-3 * ----- | 1-14 | |
| Y | US 2018/374967 A1 (MAGAÑA-SANDOVAL FABIAN [US] ET AL) 27 December 2018 (2018-12-27) * paragraphs [0004], [0005], [0019] – [0026]; figures 2-10 * ----- | 1-14 | |

TECHNICAL FIELDS
SEARCHED       (IPC)

H01S

-/--

The present search report has been drawn up for all claims

| Place of search | Date of completion of the search | Examiner |
|---|---|---|
| Munich | 1 February 2023 | Laenen, Robert |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

**EP 22 19 4904**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | FISCHER A P A ET AL: "Experimental and theoretical study of filtered optical feedback in a semiconductor laser", IEEE JOURNAL OF QUANTUM ELECTRONICS, IEEE, USA, vol. 36, no. 3, 1 March 2000 (2000-03-01), pages 375-384, XP011449672, ISSN: 0018-9197, DOI: 10.1109/3.825886 * page 375, right-hand column, paragraph 4 – page 377, right-hand column, paragraph 1; figures 1,2 * | 1,13 | |

-----

**TECHNICAL FIELDS SEARCHED (IPC)**

The present search report has been drawn up for all claims

| Place of search | Date of completion of the search | Examiner |
|---|---|---|
| Munich | 1 February 2023 | Laenen, Robert |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
...............................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 22 19 4904

This annex lists the patent family members relating to the patent documents cited in the above-mentioned European search report.
The members are as contained in the European Patent Office EDP file on
The European Patent Office is in no way liable for these particulars which are merely given for the purpose of information.

01-02-2023

| Patent document cited in search report | | Publication date | Patent family member(s) | | Publication date |
|---|---|---|---|---|---|
| US 2007115782 | A1 | 24-05-2007 | EP | 1700299 A1 | 13-09-2006 |
| | | | JP | 2007516556 A | 21-06-2007 |
| | | | KR | 20060107816 A | 16-10-2006 |
| | | | TW | 200527788 A | 16-08-2005 |
| | | | US | 2007115782 A1 | 24-05-2007 |
| | | | WO | 2005064604 A1 | 14-07-2005 |
| US 2018374967 | A1 | 27-12-2018 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 21216871

### Non-patent literature cited in the description

- **DIORICO, FRITZ ; ARTEM ZHUTOV ; ONUR HOSTEN.** Laser-cavity locking at the 10^(-7) instability scale utilizing beam elipticity. *arXiv preprint arXiv:2203.04550,* 2022
- **OTTAWAY, D. J. et al.** Stabilization of injection-locked lasers using spatial mode interference. *IEEE journal of quantum electronics,* 2001, vol. 37 (5), 653-657
- **SHADDOCK, D. A. ; M. B. GRAY ; D. E. MCCLELLAND.** Frequency locking a laser to an optical cavity by use of spatial mode interference. *Optics letters,* 1999, vol. 24 (21), 1499-1501